# EUROPEAN PATENT APPLICATION

(11) **EP 4 700 141 A1**
(43) Date of publication of application: **25.02.2026**
(21) Application number: 24195915.4
(22) Date of filing: 22.08.2024
(51) Int. Cl.: C22C 29/08, B22F 5/00, C22C 1/051, C23C 14/35, C23C 14/32, B22F 3/24

(54) **COATED CUTTING TOOL**

(71) Applicant: AB Sandvik Coromant, 811 81 Sandviken (SE)
(72) Inventor: Garcia, José, Sandviken (SE); Chychko, Andrei, Sandviken (SE); Lattemann, Martina, Sandviken (SE); Chico, Jonathan, Sandviken (SE); Holmström, Erik, Sandviken (SE)
(74) Representative: Sandvik

(57) **Abstract**

The present invention relates to a coated cutting tool comprising a coating and a cemented carbide substrate where the cemented carbide comprises WC and a Ni-based metal binder wherein the metal binder comprises Ni, Fe and Cr so that the weight ratio Ni/(Ni+Fe) is between 0.68 and 0.90; and the Cr content in the cemented carbide is such that the weight ratio Cr/(Cr+Ni+Fe) is between 0.03 and 0.12, and wherein the coating is a PVD coating.

## Description

The present invention relates to a coated cutting tool comprising a cemented carbide substrate wherein the substrate has a Ni-based metal binder comprising Ni, Fe and Cr.

### Background

The market of cutting tools for chip forming metal cutting operations is dominated by CVD (Chemical Vapor Deposition) and PVD (Physical Vapor Deposition) coated cemented carbides wherein the cemented carbide usually is made of WC in a metallic binder of Co.

In recent years, efforts to replace Co has been done due its hazardous properties and the fact that Co is considered to be a so called critical raw material. This have led to an increased activity to develop binders either with a reduced amount of cobalt or completely cobalt free. Despite this, metal binders with a reduced amount of Co or even without Co are still rare or non-existing in the products on the market. There are several reasons for this, one is that it is difficult to achieve substrate properties that can match those for cemented carbide with cobalt binders. Upscaling the production of these new cemented carbides is also challenging.

It is an object of the present invention to provide a coated cutting tool for metal cutting having a cemented carbide substrate with a Ni-based binder having a performance equal to, or improved, compared to when Co is used as binder.

### Detailed description of the present invention

The present invention relates to a coated cutting tool comprising a cemented carbide substrate and a coating, where the cemented carbide comprises WC and 2 to 20 wt% of a Ni-based metal binder, wherein the metal binder comprises Ni, Fe and Cr so that the weight ratio Ni/(Ni+Fe) in the cemented carbide is between 0.68 and 0.90; and the Cr content in the cemented carbide is such that the weight ratio Cr/(Cr+Ni+Fe) is between 0.03 and 0.12;
wherein the coating is a PVD coating.

By cemented carbide is herein meant that at least 50 wt% of the hard phase, is WC. By hard phase is herein meant all phases except the metal binder phase.

By Ni-based binder is herein meant that the binder contains at least 60 wt% Ni.

The metal binder is present in an amount of 2 to 20 wt% of the sintered cemented carbide, preferably between 5 to 12 wt% of the sintered cemented carbide. Although the binder can contain other dissolved elements than Ni and Fe the weight % binder given herein, is the total amount of Ni and Fe. The amounts of Ni and Fe are either given by the amount of raw material used or measured using conventional chemical analysis.

Although, the main elements in the binder are Ni and Fe it is well known in the art of cemented carbide manufacturing that other elements, e.g. W from the WC, Cr etc. will be present in the metal binder since they are inevitably dissolved in the metal binder during sintering. If other common additives, such as cubic carbides etc. are added, elements such as Ti, Nb, Ta, V etc. can also be found on the metal binder.

The Ni-based metal binder comprises mainly of Ni and Fe and by that is herein meant that at least 80 wt% of the binder consists of Ni and Fe.

The cemented carbide according to the present invention comprises Ni and Fe is such amounts that the weight ratio Ni/(Ni+Fe) is between 0.68 and 0.90, preferably between 0.70 and 0.87, more preferably between 0.72 and 0.74, or between 0.83 and 0.87. If the Ni content is too high, the hardness of the cemented carbide will be too low. If the Ni content is too low, the mechanical properties of the substrate such as hardness and toughness, will not suffice and the overall performance of the cutting tool will be inferior.

Cr is a common addition in cemented carbides but the amount of Cr that can be added is usually limited by the solubility of Cr in the metal binder. If the amount of Cr exceeds the solubility in the binder, a brittle carbide, Cr₇C₃, is precipitated in the microstructure and the mechanical properties of the cemented carbide will deteriorate which can influence the overall performance of the cutting tool.

Cr is to be added up to the limit where Cr₇C₃ is formed, however, for practical reasons it is not suitable to be too close to that limit. Suitably the weight fraction Cr/(Cr+Ni+Fe) is between 0.03 and 0.12, preferably between 0.035 and 0.095, more preferably between 0.070 and 0.11.

If the amount of Cr is too low, no improvement on the hardness and other mechanical properties can be seen and thus no improvement in performance in metal cutting will be achieved.

The cemented carbide according to the present invention is essentially free from Co. By that is herein meant that no Co powder is added. Co can however be present in smaller amounts due to contamination if the same manufacturing equipment is used as for Co containing cemented carbides and/or if the milling ball media is made of Co containing cemented carbide. By essentially free from Co is herein meant that the cemented carbide comprises less than 1 wt% Co, preferably less than 0.5wt %. The Co content is measured according to standard practice when doing chemical analysis on cemented carbides.

The cemented carbide according to the present invention can have any average WC grain size known for cutting tools. Preferably the average WC grain size is between 0.1 and 12 µm, more preferably between 0.4 and 9 µm as measured by the linear intercept method. The average WC grain size that is aimed for is however chosen depending on the specific cutting application.

The carbon content in the sintered cemented carbide should be selected so that neither eta phase nor free graphite is present in the cemented carbide microstructure after sintering. If the carbon content is too low, eta phase can form. If the carbon content is too high, graphite can form in the material. Methods for adjusting the carbon balance to achieve this is well known to a person skilled in the art of making cemented carbides.

In one embodiment of the present invention, the cemented carbide comprises gamma phase, sometimes also called cubic phase. Gamma phase is formed during sintering if one or more gamma phase forming elements, e.g. Ti, Ta, Nb, Zr, V, Mo, Cr, Hf are present and can be written with the general formula (W,X)(C,N) or (W,X)(C) where X can be one or more gamma phase forming elements. The amount of gamma phase is suitably from 1 to 20 vol%, preferably from 2 to 7 vol%. This can be measured in different ways preferably by making an image analysis, e.g. by using Image J, on either a Light Optical Microscope (LOM) image or a Scanning Electron Microscope (SEM) micrograph of a cross section of the substrate to calculate the average fraction of gamma phase.

According to the present invention, the coating is a PVD coating.

Typically, a PVD coating for cutting tools can have a composition being a nitride and/or carbonitride and/or oxide of one or more of Ti, Al, Si and Cr. Also other elements can be present. Preferably, the PVD coating is a nitride that has an average composition so that at least 70 at% of the metallic elements constitute Ti, Al, Si and Cr. The PVD coating can be either a homogeneous coating or contain at least one section that have a multilayer structure, where the individual layers have a thickness in the nano-range, e.g. between 2-100 nm.

In one embodiment of the present invention the coating typically has a total thickness of between 1 and 15 µm, preferably between 1 and 10 µm.

The specific coating thickness, chemical composition and structure e.g. homogenous/nanolayered, depends on the specific cutting application in mind.

A PVD coating can also be defined as a coating that has compressive stresses. This can be measured by e.g. XRD.

In one embodiment of the present invention, the coating is a homogenous TiₓAl₁₋ₓN coating where x is 0.25- 0.9, preferably between 0.3 and 0.5 with a thickness of between 0.5 and 4 µm.

### Embodiments

In one embodiment of the present invention, the cemented carbide consists of the elements W, Ni, Fe, Cr and C and unavoidable impurities.

In one embodiment of the present invention, the cemented carbide consists of the elements W, Ni, Fe, Cr, Ti, Ta, Nb, C and N and unavoidable impurities.

In one embodiment of the present invention the coated cutting tool comprises a substrate comprising WC and Ni-based metal binder where the weight ratio Ni/(Ni+Fe) is between 0.72 and 0.74; and the Cr content in the cemented carbide is such that the weight ratio Cr/(Cr+Ni+Fe) is between 0.07 and 0.11.

In one embodiment of the present invention the coated cutting tool comprises a substrate comprising WC and Ni-based metal binder where the weight ratio Ni/(Ni+Fe) is between 0.83 and 0.87; and the Cr content in the cemented carbide is such that the weight ratio Cr/(Cr+Ni+Fe) is between 0.07 and 0.11.

In one embodiment of the present invention the coated cutting tool comprises a substrate comprising WC and Ni-based metal binder where the weight ratio Ni/(Ni+Fe) is between 0.72 and 0.74; and the Cr content in the cemented carbide is such that the weight ratio Cr/(Cr+Ni+Fe) is between 0.03 and 0.05.

By cutting tool is herein meant an insert, end mill or drill.

In one embodiment of the present invention, the cutting tool is an insert, preferably a turning or milling insert.

The present invention also relates to a method of making a cutting tool according to the above.

The method comprises the following steps:
- providing a WC powder;
- providing powder(s) comprising the elements Fe, Ni and Cr;
- mixing the powders with a milling liquid to form a slurry, drying said slurry into granules,
- pressing and sintering said granules into a sintered cemented carbide substrate; depositing a coating onto said substrate using physical vapor deposition at a deposition temperature less than 800°C.

The raw materials comprising the elements Fe, Ni and Cr can be added as pure metals, alloys of two or more metals or as carbides, nitrides or carbonitrides thereof. The raw materials should be added in such amounts so that the binder phase, after sintering will have the composition as has been described above.

In one embodiment of the present invention, the powders are Cr₃C₂, Fe and Ni.

The WC powder used has an average particle size of 0.2-10 µm, more preferably 0.2-5 µm (FSSS). The exact WC particle size is chosen based on the actual application for the cutting tool in mind.

In one embodiment of the present invention, when a gamma phase is desired, powders comprising one or more of carbides, nitrides or carbonitrides of one or more of Ti, Ta, Nb, Zr, V, Mo, Cr and Hf are added to form the gamma phase during sintering.

Any liquid commonly used as a milling liquid in conventional cemented carbide manufacturing can be used. The milling liquid is preferably water, alcohol or an organic solvent, more preferably water or a water and alcohol mixture and most preferably a water and ethanol mixture. The properties of the slurry are dependent on the amount of milling liquid added. Since the drying of the slurry requires energy, the amount of liquid should be minimized to keep costs down. However, enough liquid needs to be added to achieve a pumpable slurry and avoid clogging of the system. Also, other compounds commonly known in the art can be added to the slurry e.g. dispersion agents, pH-adjusters etc.

An organic binder is also optionally added to the slurry in order to facilitate the granulation during the following spray drying operation but also to function as a pressing agent for any following pressing and sintering operations. The organic binder can be any binder commonly used in the art. The organic binder can e.g. be paraffin, polyethylene glycol (PEG), long chain fatty acids etc. The amount of organic binder is suitably between 15 and 25 vol% based on the total dry powder volume, the amount of organic binder is not included in the total dry powder volume.

The slurry comprising powders forming hard constituents and powders forming the binder phase, and possibly an organic binder is suitably mixed by a milling operation, either in a ball mill or attritor mill. The milling is suitably made by first forming a slurry comprising metal binder powder, the first and second powder fraction, and possibly an organic binder. Then the slurry is suitably milled in a ball mill or attritor mill to obtain a homogenous slurry blend.

The slurry containing the powdered materials mixed with the organic liquid and possibly the organic binder is atomized through an appropriate nozzle in the drying tower where the small drops are instantaneously dried by a stream of hot gas, for instance in a stream of nitrogen, to form agglomerated granules. For small scale experiments, also other drying methods can be used, e.g. pan drying.

Green bodies are subsequently formed from the dried powders/granules by a pressing operation such as uniaxial pressing, multiaxial pressing etc.

The green bodies formed from the powders/granules made according to the present invention, is subsequently sintered according to any conventional sintering methods e.g. vacuum sintering, sinter HIP, spark plasma sintering, gas pressure sintering (GPS) etc.

In one embodiment of the present invention, the sintering temperature is between 1350°C and 1550°C, preferably between 1380°C and 1470°C.

The coating is deposited using physical vapor deposition (PVD) at a temperature below 800°C. If the deposition temperature is above 800°C, Ni and possibly other elements in the cemented carbide substrate can diffuse into the coating and alter the coating properties. The PVD process is typically either arc evaporation or magnetron sputtering.

### Examples

Cemented carbide substrates were manufactured from the powder compositions given in Table 1.

**Table 1**

| | Co (wt%) | Ni (wt%) | Fe (wt%) | Cr₃C₂ (wt%) | W (wt%) | Carbon (wt%) | WC (wt%) |
|---|---|---|---|---|---|---|---|
| Invention 1 | 0.0 | 7.3 | 2.7 | 0.5 | 0.2 | 0.1 | 89.4 |
| Invention 2 | 0.0 | 7.3 | 2.7 | 1.2 | 0.3 | 0.1 | 88.7 |
| Invention 3 | 0.0 | 8.3 | 1.5 | 1.2 | 0.9 | 0.1 | 88.9 |
| Comparative 1 | 10.0 | 0.0 | 0.0 | 0.8 | n.a. | n.a. | 89.1 |
| Comparative 2 | 10.0 | 0.0 | 0.0 | 0.7 | 0.3 | 0.1 | 89.1 |

The WC powder had an average particle size (FSSS) of 0.9 µm. Adjustment of the carbon balance by adding carbon was done to avoid eta and graphite formation. The raw material powders were milled in an attritor mill for 2h together with an organic binder (2 wt% PEG based on total powder weight) and a milling liquid (ethanol) to form a slurry which was vacuum dried to obtain a powder blend. The powder was pressed into green bodies. The green bodies were sintered in a vacuum furnace where maximum sintering temperature was 1550°C and sintering time was 1 h at 0.01 mbar vacuum sintering.

For comparison, two substrates having Co as a binder were produced in a similar manner as the inventive samples. The powder compositions are given in Table 1. These samples are herein denoted Comparative 1 and 2.

All substrates were coated in the same PVD coating process. The PVD coating was a homogenous coating with an average composition of Ti₄₀Al₆₀N with an average thickness of 1.5 µm deposited by arc evaporation.

### Working example 1

The coated inserts from Example 1 were tested in a turning cutting test in Alloy Steel (JIS:SCM440) where flank wear and plastic deformation was evaluated.
V_{c} = 220 m/min
F = 0.3 mm/rev
aₚ= 1.5 mm
Dry cutting.

**Table 2**

| | Ni/(Ni+Fe) | Cr/(Cr+Ni+Fe) | Flank wear width (VB) after 3 minutes (µm) | Plastic deformation after 3 minutes (µm) |
|---|---|---|---|---|
| Invention 1 | 0.73 | 0.042 | 79 | 21 |
| Invention 2 | 0.73 | 0.094 | 52 | 5 |
| Invention 3 | 0.85 | 0.096 | 61 | 10 |
| Comparative 1 | - | - | 137 | 26 |
| Comparative 2 | - | - | 151 | 22 |

As can be seen in Table 2, the inserts according to the present invention shows both an increased resistance against flank wear and plastic deformation. The Ni/(Ni+Fe) and Cr/(Cr+Ni+Fe) weight ratios are calculated from the values in Table 1.

### Working Example 2

The coated inserts from Example 1 were tested in a turning cutting test in Alloy Steel (JIS:SCM440) where flank wear and plastic deformation was evaluated.
V_{c}= 180 m/min
f= 0.3 mm/rev
aₚ= 1.5 mm
Dry cutting

**Table 3**

| | Ni/(Ni+F e) | Cr/(Cr+Ni+Fe) | Flank wear width (VB) after 11 minutes (µm) | Plastic deformation after 11 minutes (µm) |
|---|---|---|---|---|
| Invention 1 | 0.73 | 0.042 | 104 | 13 |
| Invention 2 | 0.73 | 0.094 | 88 | 6 |
| Invention 3 | 0.85 | 0.096 | 33 | 12 |
| Comparative 1 | - | - | 79 | 24 |
| Comparative 2 | - | - | 90 | 22 |

As can be seen in Table 2, the inserts according to the present invention shows an increased resistance against plastic deformation while the flank wear is almost maintained. The Ni/(Ni+Fe) and Cr/(Cr+Ni+Fe) weight ratios are calculated from the values in Table 1.

## Claims

1. A coated cutting tool comprising a cemented carbide substrate and a coating, wherein the cemented carbide comprises WC and 2 to 20 wt% of a Ni-based metal binder, wherein the metal binder comprises Ni, Fe and Cr so that
the weight ratio Ni/(Ni+Fe) in the cemented carbide is between 0.68 and 0.90; and
the Cr content in the cemented carbide is such that the weight ratio Cr/(Cr+Ni+Fe) is between 0.03 and 0.12;
wherein the coating is a PVD coating.

2. A coated cutting tool according to claim 1 wherein the Cr content in the cemented carbide is such that the weight ratio Cr/(Cr+Ni+Fe) is between 0.070 and 0.11.

3. A coated cutting tool according to any of the preceding claims wherein the weight ratio Ni/(Ni+Fe) in the cemented carbide is between 0.72 and 0.87;

4. A coated cutting tool according to any of the preceding claims wherein the weight ratio Ni/(Ni+Fe) in the cemented carbide is between 0.72 and 0.74.

5. A coated cutting tool according claim 4 wherein the weight ratio Cr/(Cr+Ni+Fe) is between 0.03 and 0.05.

6. A coated cutting tool according to any of claims 1-3 wherein the weight ratio Ni/(Ni+Fe) in the cemented carbide is between 0.83 and 0.87.

7. A coated cutting tool according to any of claims 4 and 6 wherein the weight ratio Cr/(Cr+Ni+Fe) is between 0.07 and 0.11.

8. A coated cutting tool according to any of the preceding claims wherein the cemented carbide is essentially free from Co.

9. A coated cutting tool according to any of the preceding claims wherein the metal binder to more than 80 wt% of the binder consists of Ni and Fe.

10. coated cutting tool according to any of the preceding claims wherein the coating is a nitride and/or carbonitride and/or oxide of one or more of Ti, Al, Si and Cr and have a total thickness of between 1 and 15 µm.

11. A coated cutting tool according to any of the preceding claims wherein the coating is a homogenous TiₓAl₁₋ₓN coating where x is 0.25- 0.9, preferably between 0.3 and 0.5 with a thickness of between 0.5 and 4 µm.

12. A method of making a coated cutting tool according to any of the claims 1-11 comprising the steps of:
- providing a WC powder;
- providing powder(s) comprising the elements Fe, Ni and Cr;
- mixing the powders with a milling liquid to form a slurry, drying said slurry into granules,
- pressing and sintering said granules into a sintered cemented carbide substrate,
- depositing a coating onto said substrate using physical vapor deposition (PVD) at a deposition temperature less than 800°C.

13. A method of making a coated cutting tool according to claim 12 wherein the physical vapor deposition (PVD) is arc evaporation or magnetron sputtering.
